# EUROPEAN PATENT APPLICATION

(11) **EP 4 254 673 A1**
(43) Date of publication of application: **04.10.2023**
(21) Application number: 21897717.1
(22) Date of filing: 10.11.2021
(51) Int. Cl.: H01R 12/57, H01R 13/24

(54) **CONNECTION COMPONENT, SHIELD MODULE, AND ELECTRONIC DEVICE**

(30) Priority: 30.11.2020 JP 2020198996
(71) Applicant: Kyocera Corporation, Kyoto-shi Kyoto 612-8501 (JP)
(72) Inventor: ARAI Ryutaro, Kyoto-shi, Kyoto 612-8501 (JP)
(74) Representative: Viering, Jentschura & Partner mbB Patent- und Rechtsanwälte
(86) International application number: PCT/JP2021/041398
(87) International publication number: WO 2022/113743

(57) **Abstract**

A connection component that connects a connection object to a circuit board includes an insertion section, an elastic portion, a side wall, and a mounting portion. The connection object is to be inserted to the insertion section. The elastic portion is to come into contact with the connection object. The side wall is connected to the elastic portion and extends in a first direction in which the elastic portion deforms elastically. The mounting portion is connected to the side wall, and the mounting portion is to be mounted on the circuit board.

## Description

### CROSS-REFERENCE TO RELATED APPLICATIONS

This application claims the benefit of Japanese Patent Application No. 2020-198996 filed November 30, 2020, which is hereby incorporated by reference herein in its entirety.

### TECHNICAL FIELD

The present disclosure relates to a connection component, a shield module, and an electronic device.

### BACKGROUND OF INVENTION

Various communication functions are implemented in electronic devices including industrial electronic devices and vehicle-mounted electronic devices as well as information devices, such as smartphones. Shielding arrangement inside an electronic device becomes increasingly important to implement such communication functions in order to improve and stabilize communication characteristics, such as transmission speed. As an example, connection components mounted on a circuit board engage and hold a connection object, such as a shielding case.

This technique is known and has been used for the shielding arrangement. For example, Patent Literature 1 discloses a contact that can reduce the likelihood of a solder fillet interfering with elastic deformation of an elastic contact portion and impairing design spring characteristics in a structure in which the elastic contact portion projects from a portion to be brought into contact with a first member, such as a circuit board.

### CITATION LIST

### PATENT LITERATURE

Patent Literature 1: Japanese Unexamined Patent Application Publication No. 2020-077539

### SUMMARY

According to an embodiment of the present disclosure, a connection component that connects a connection object to a circuit board includes an insertion section, an elastic portion, a side wall, and a mounting portion. The connection object is to be inserted to the insertion section. The elastic portion is to come into contact with the connection object. The side wall is connected to the elastic portion and extends in a first direction in which the elastic portion deforms elastically. The mounting portion is connected to the side wall, and the mounting portion is to be mounted on the circuit board.

According to an embodiment of the present disclosure, a shield module includes the above-described connection component and the connection object. The connection object is inserted in the insertion section and is connected to the circuit board by the connection component. The connection object includes a shielding case.

According to an embodiment of the present disclosure, an electronic device includes the above-described connection component or the above-described shield module.

### BRIEF DESCRIPTION OF THE DRAWINGS

FIG. 1 is a perspective view illustrating the exterior of a shield module according to an embodiment as viewed from above, in which a connection object engages connection components.
FIG. 2 is a perspective view illustrating the exterior of a connection component according to an embodiment as viewed from above.
FIG. 3 is a front view of the connection component of FIG. 2.
FIG. 4 is a rear view of the connection component of FIG. 2.
FIG. 5 is a top view of the connection component of FIG. 2.
FIG. 6 is a bottom view of the connection component of FIG. 2.
FIG. 7 is a left side view of the connection component of FIG. 2.
FIG. 8 is a cross-sectional view of the connection component taken along line VIII-VIII in FIG. 2.
FIG. 9 is a view schematically illustrating the connection component of FIG. 2, in which the connection component is being transported toward a circuit formation surface of the circuit board.
FIG. 10 is a first view illustrating a state in which the connection object is being inserted into the connection component.
FIG. 11 is a second view illustrating a state in which the connection object is being inserted into the connection component.
FIG. 12 is a third view illustrating a state in which the connection object is being inserted into the connection component.
FIG. 13 is a perspective view illustrating the exterior of a connection component according to a variation as viewed from above, and FIG. 13 corresponds to the perspective view of FIG. 2.
FIG. 14 is a perspective view illustrating the exterior of the connection component of FIG. 13 as viewed from an opposite side.

### DESCRIPTION OF EMBODIMENT

Reliability is a key factor in, for example, industrial electronic devices and vehicle-mounted electronic devices. A known connection component as described in Patent Literature 1 may encounter a problem that, for example, elastic deformation of an elastic portion has a negative effect on a mounting portion and may cause cracks in a solder portion due to stresses generated by the elastic deformation. Such a problem reduces the reliability of an electronic device containing the known connection component.

A connection component, a shield module, and an electronic device according to an embodiment of the present disclosure can reduce the likelihood of the problem occurring due to the elastic deformation of the elastic portion of the connection component.

An embodiment of the present disclosure is described in detail with reference to the drawings. As used herein, directions, such as a front-rear direction, a right-left direction, and an up-down direction, are defined with reference to arrow directions in the drawings. The arrow directions are coordinated in different drawings. In some drawings, a circuit board CB (to be described later) may be omitted for the purpose of plain illustration.

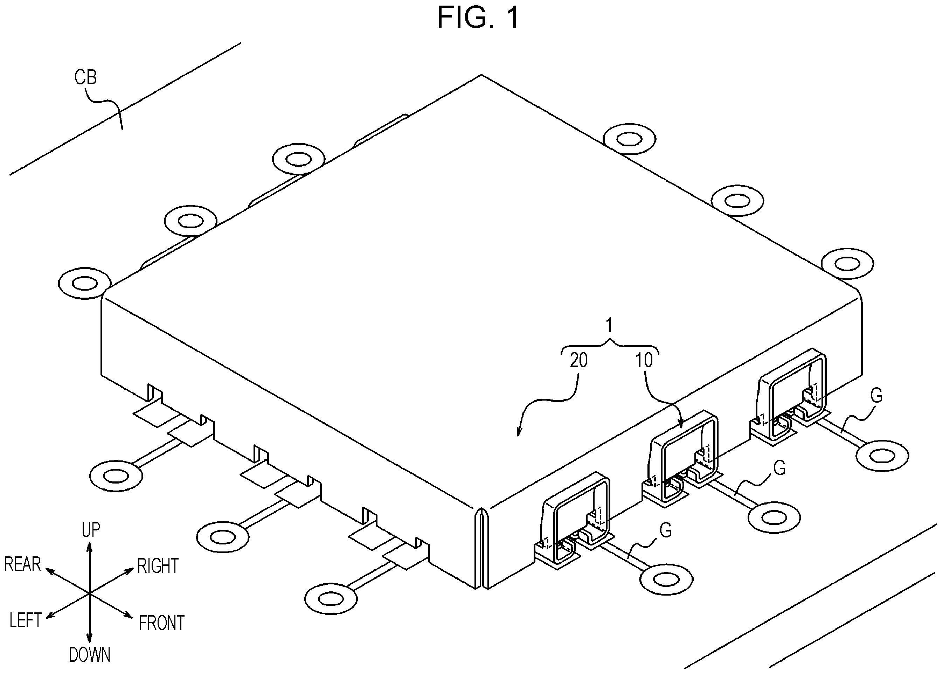

FIG. 1 is a perspective view illustrating the exterior of a shield module 1 according to an embodiment as viewed from above, in which a connection object 20 engages connection components 10. The following description focuses on the structure and the function of the shield module 1 according to the embodiment with reference to FIG. 1.

The shield module 1 includes the connection components 10 and the connection object 20. The connection object 20 is inserted into an insertion section 15 (to be described later) of each connection component 10 and is connected to the circuit board CB by the connection components 10.

The connection components 10 of the present embodiment are mounted on the circuit board CB. The circuit board CB may be a rigid circuit board or may be an arbitrary circuit board other than that or part of a housing of a device. The connection components 10 electrically connect the circuit board CB to the connection object 20 that engages, and is held by, the connection components 10. The connection object 20 can be inserted into and removed from the connection components 10. The connection components 10 hold the connection object 20 while the connection object 20 is inserted in the connection components 10.

The connection object 20, which is part of the shield module 1, may be a shielding case. The connection object 20, however, is not limited to the shielding case but may be an arbitrary object to be connected to the circuit board CB using the connection components 10. For example, the connection object 20 may be a circuit board different from the circuit board CB, such as a flexible printed circuit board (FPC) or a flexible flat cable (FFC), or may be an electric wire, a radiator plate, or a housing of an electronic device. In such cases, the connection components 10 and the connection object 20 may constitute an arbitrary module, other than the shield module 1, that is suitable for the function of a particular connection object 20.

In the shield module 1, for example, three connection components 10 are mounted on the circuit board CB at predetermined intervals in the right-left direction at a position corresponding to each of the side edges of the connection object 20 opposite in the front-rear direction. The connection object 20, which is the shielding case in this case, is held by six connection components 10 that are mounted on the circuit board CB while part of the connection object 20 is inserted into the six connection components 10. While the connection object 20 is connected to the circuit board CB in this manner, the connection object 20 accommodates other electronic components that are also mounted on the circuit formation surface of the circuit board CB as are the connection components 10. The connection object 20 thereby shields these electronic components. Examples of the above electronic components include a communication module, a central processing unit (CPU), a controller, and a memory.

As used herein, the term "first direction" refers, for example, to the front-rear direction. The term "second direction" refers, for example, to the right-left direction. The term "insertion direction of the connection object" refers, for example, to the up-down direction.

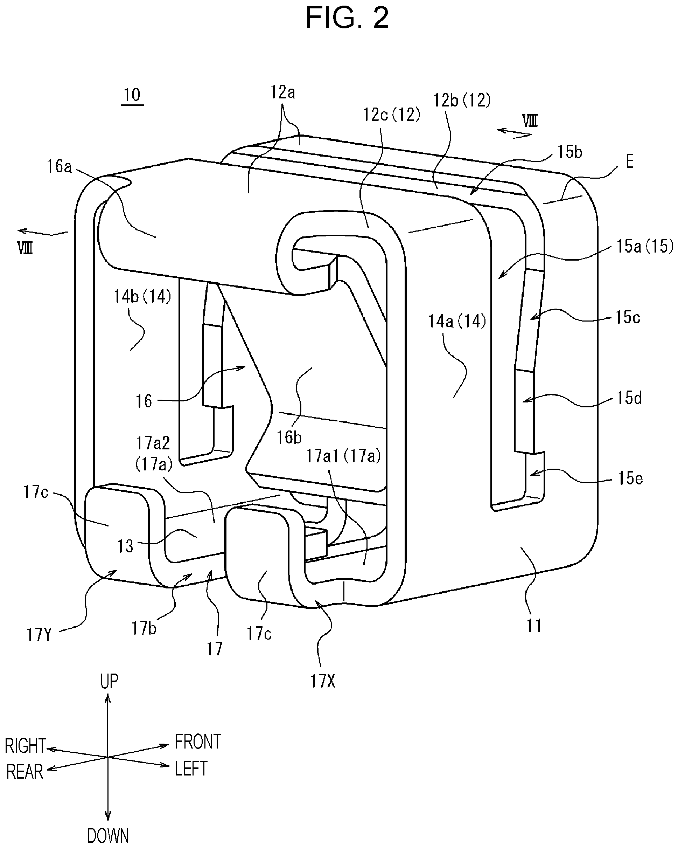

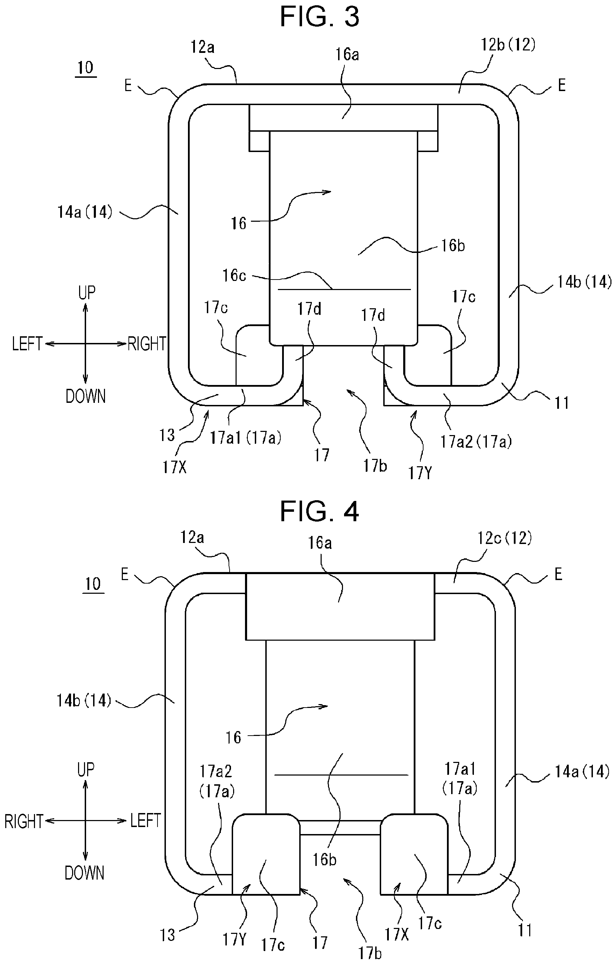

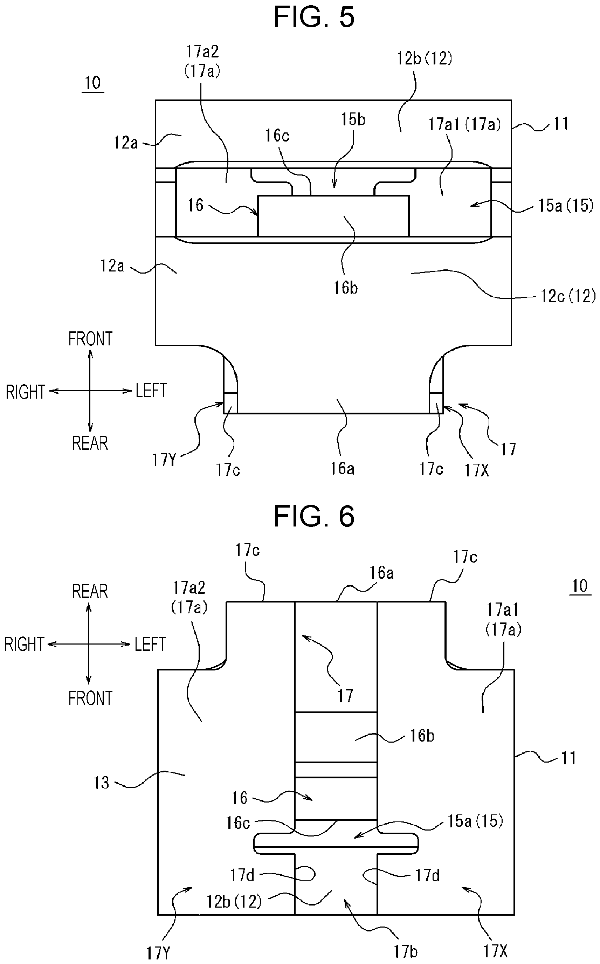

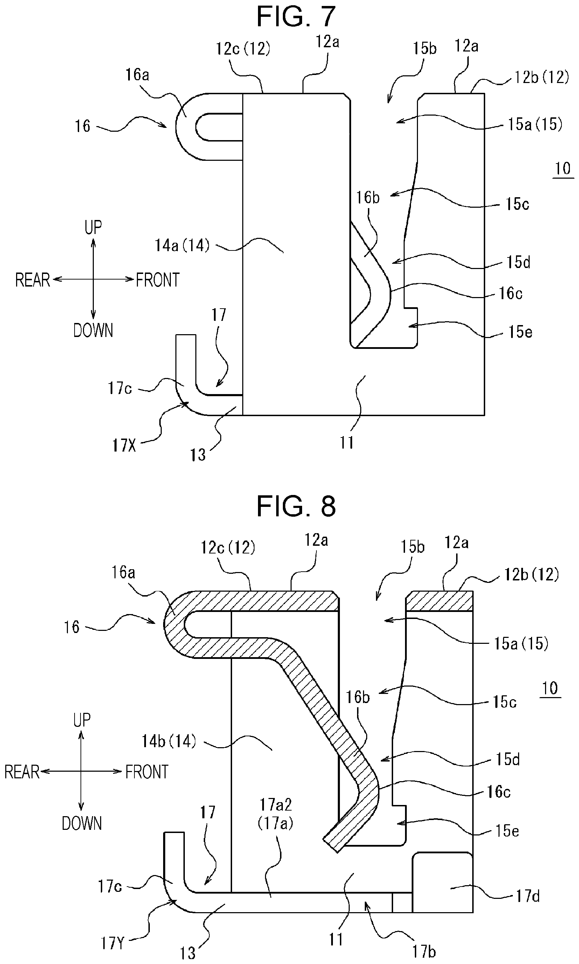

FIG. 2 is a perspective view illustrating the exterior of the connection component 10 of the present embodiment as viewed from above. FIG. 3 is a front view of the connection component 10 of FIG. 2. FIG. 4 is a rear view of the connection component 10 of FIG. 2. FIG. 5 is a top view of the connection component 10 of FIG. 2. FIG. 6 is a bottom view of the connection component 10 of FIG. 2. FIG. 7 is a left side view of the connection component 10 of FIG. 2. FIG. 8 is a cross-sectional view of the connection component 10 taken along line VIII-VIII in FIG. 2. Referring to FIGs. 2 to 8, the following description focuses on the structure of the connection component 10 of the present embodiment.

The connection component 10 is produced by shaping an arbitrary metal plate substantially into a cuboid using a progressive die forming technique (stamping). The connection component 10 is formed by punching out a metal piece and bending the metal piece in the thickness direction. For example, the surfaces of the connection component 10 are plated with gold, tin, silver, or nickel, or by tin-reflowing. The surfaces of the connection component 10, however, do not need to be plated.

The connection component 10 includes a circumferential wall 11 that is formed rectangularly as a whole. The circumferential wall 11 includes four outer walls that face in the up-down direction and in the right-left direction. The circumferential wall 11 includes a ceiling wall 12, a bottom wall 13, and side walls 14. The circumferential wall 11 includes two corner portions at which the ceiling wall 12 is connected the side walls 14 and another two corner portions at which the bottom wall 13 is connected to the side walls 14. These corner portions are rounded. The circumferential wall 11 serves as the outer frame of the connection component 10.

The ceiling wall 12 includes a suction surface 12a that is the outside surface of the ceiling wall 12. The suction surface 12a extends rectangularly in the front-rear and the right-left directions. The ceiling wall 12 extends inward from an edge E of each side wall 14 in the second direction that orthogonally intersects the first direction. The edge E of each side wall 14 is located opposite to the edge near a mounting portion 17 (to be described later). For example, the ceiling wall 12 extends inward in the right-left direction from the upper edge of each side wall 14. The ceiling wall 12 is divided into front and rear portions by a first slit 15a (to be described later), and the front portion is a first ceiling wall 12b and the rear portion is a second ceiling wall 12c. Accordingly, the suction surface 12a is divided by the first slit 15a into front and rear portions.

The side walls 14 are connected to an elastic portion 16 (to be described later). The side walls 14 extend in the first direction in which the elastic portion 16 is elastically deformed. For example, the side walls 14 extend in the front-rear direction in which the elastic portion 16 is elastically deformed. The side walls 14 oppose each other in the second direction with the elastic portion 16 located therebetween. The left one is a first side wall 14a and the right one is a second side wall 14b. For example, the elastic portion 16 is located between the first side wall 14a and the second side wall 14b in the right-left direction. Each side wall 14 is shaped like the letter U as viewed sideways. Both the first side wall 14a and the second side wall 14b are shaped like the letter Us. The first ceiling wall 12b connects the upper edges of respective front portions of the first and second side walls 14a and 14b, while the second ceiling wall 12c connects the upper edges of respective rear portions of the first and second side walls 14a and 14b.

The connection component 10 includes an insertion section 15. The insertion section 15 is formed such that the ceiling wall 12, the first side wall 14a, and the second side wall 14b are notched in the up-down direction almost at full length so as to have an inverse U-shape.

The insertion section 15 includes the first slit 15a that is formed through the ceiling wall 12 into the first side wall 14a and into the second side wall 14b in the insertion direction of the connection object 20 that orthogonally intersects the first direction and the second direction. For example, the first slit 15a is formed so as to transverse a front half portion of the ceiling wall 12 entirely in the right-left direction. The first slit 15a is formed in the side walls 14 straight downward from the front half portion of the ceiling wall 12 to a position near the bottom wall 13.

The insertion section 15 includes an opening 15b formed at the ceiling wall 12. The opening 15b of the first slit 15a is defined by a pair of edges of the ceiling wall 12 formed in the front half portion thereof. The pair of edges extend in the right-left direction. The insertion section 15 includes a tapered section 15c formed in an upper half portion of each side wall 14 at a position below the opening 15b. The width of the insertion section 15 in the front-rear direction decreases as it goes down along the tapered section 15c. The insertion section 15 includes a support section 15d that is connected to the lower end of the tapered section 15c. The width of the support section 15d in the front-rear direction is smaller than that of the opening 15b due to the presence of the tapered section 15c. The insertion section 15 also includes a recess 15e that is connected to the lower end of the support section 15d.

As illustrated in FIG. 7, for example, the insertion section 15 is formed asymmetrically in the front-rear direction. For example, the rear side edge of each side wall 14 in the first slit 15a extends straight entirely in the up-down direction. On the other hand, the front side edge of each side wall 14 in the first slit 15a extends obliquely rearward as it goes down in an upper half section of the first slit 15a, the upper half section positionally corresponding to the tapered section 15c. In the support section 15d, the front side edge of each side wall 14 in the first slit 15a extends straight in the up-down direction. In the recess 15e, the front side edge of each side wall 14 in the first slit 15a is formed at a more frontward position and extends straight in the up-down direction. The width of the insertion section 15 in the front-rear direction is largest at the opening 15b and in the recess 15e. The width of the insertion section 15 in the front-rear direction becomes gradually small in the tapered section 15c and is smallest in the support section 15d.

The connection component 10 includes an elastic portion 16 that projects into the insertion section 15. The elastic portion 16 is connected to the ceiling wall 12 and further to the side walls 14 via the ceiling wall 12. The elastic portion 16 extends from an edge of the ceiling wall 12 in the first direction, turns back, and projects into the insertion section 15. For example, the elastic portion 16 extends from the rear edge of the second ceiling wall 12c, turns back, and further extends obliquely downward into the first slit 15a of the insertion section 15.

The elastic portion 16 includes a folded portion 16a at which the elastic portion 16 is shaped like the letter U, in other words, the elastic portion 16 is folded frontward from the rear edge of the second ceiling wall 12c. The elastic portion 16 further includes an extension 16b that extends obliquely downward from an end of the folded portion 16a, the end being located opposite to the second ceiling wall 12c. For example, the extension 16b is shaped like the letter L. The extension 16b extends frontward and obliquely downward from the folded portion 16a, and subsequently bends, and further extends rearward and obliquely downward. The elastic portion 16 includes a contact 16c that is a bent portion of the extension 16b. The contact 16c is positioned in the first slit 15a of the insertion section 15 when the elastic portion 16 is not elastically deformed. In the up-down direction, the contact 16c is located at the position of the support section 15d of the insertion section 15. The contact 16c, which is disposed at the position of the support section 15d of the insertion section 15, narrows the insertion space for the connection object 20 in the front-rear direction at the support section 15d.

The connection component 10 includes a mounting portion 17 that is connected to the side walls 14. The mounting portion 17 is a portion to be fixed to the circuit board CB. The mounting portion 17 includes the bottom wall 13. The left edge of the mounting portion 17 is connected to the first side wall 14a, and the right edge thereof is connected to the second side wall 14b. For example, as illustrated in FIG. 5, the mounting portion 17 overlaps the elastic portion 16 as viewed in the insertion direction in which the connection object 20 is inserted into the insertion section 15. The mounting portion 17 is located at a position closer than the elastic portion 16 to the circuit board CB. For example, the mounting portion 17 overlaps the elastic portion 16 as viewed from above. The elastic portion 16 is located between the mounting portion 17 and the ceiling wall 12 in the up-down direction.

The mounting portion 17 includes a first mounting portion 17X and a second mounting portion 17Y The first mounting portion 17X is connected to the first side wall 14a, and the second mounting portion 17Y is connected to the second side wall 14b. The first mounting portion 17X and the second mounting portion 17Y oppose each other with a second slit 17b (to be described later) located therebetween. The mounting portion 17 includes a base arm 17a. The base arm 17a extends inward in the second direction, which orthogonally intersects the first direction, from an edge of each side wall 14, the edge being located near the mounting portion 17. The base arm 17a is divided into right and left portions by the second slit 17b (to be described later), and the left portion is a first base arm 17a1, and the right portion is a second base arm 17a2.

The mounting portion 17 includes the second slit 17b that is formed in the base arm 17a at the center in the second direction. The second slit 17b extends through the base arm 17a in the first direction. For example, the second slit 17b extends through the base arm 17a at full length in the front-rear direction at the central position in the right-left direction. The second slit 17b divides the base arm 17a into the first base arm 17a1 and the second base arm 17a2.

The mounting portion 17 includes a first bent arm 17c. The first bent arm 17c is bent at a position outward in the first direction from an edge of the base arm 17a, the edge extending in the second direction. For example, the first bent arm 17c projects outward in the front-rear direction from the rear edge of the base arm 17a and is shaped like the letter L. For example, two first bent arms 17c are formed. The number of the first bent arms 17c is not limited to two, but may be more than two. One of the first bent arms 17c projects outward in the front-rear direction from the rear edge of the first base arm 17a1 and is shaped like the letter L. The other one of the first bent arms 17c also projects outward in the front-rear direction from the rear edge of the second base arm 17a2 and is shaped like the letter L.

For example, as illustrated in FIGs. 3 and 8, the mounting portion 17 includes a second bent arm 17d. The second bent arm 17d is shaped like the letter L and projects inward in the second direction from an edge of the base arm 17a that extends along the second slit 17b. For example, the second bent arm 17d extends inward in the right-left direction from a front end portion of the base arm 17a. The second bent arm 17d is shaped like the letter L. For example, two second bent arms 17d are formed. One of the second bent arms 17d extends inward in the right-left direction from a front end portion of the first base arm 17a1 and is shaped like the letter L. The other one of the second bent arms 17d extends inward in the right-left direction from a front end portion of the second base arm 17a2 and is shaped like the letter L.

Next, the following description focuses on the function of the connection component 10 and of the shield module 1 according to the present embodiment.

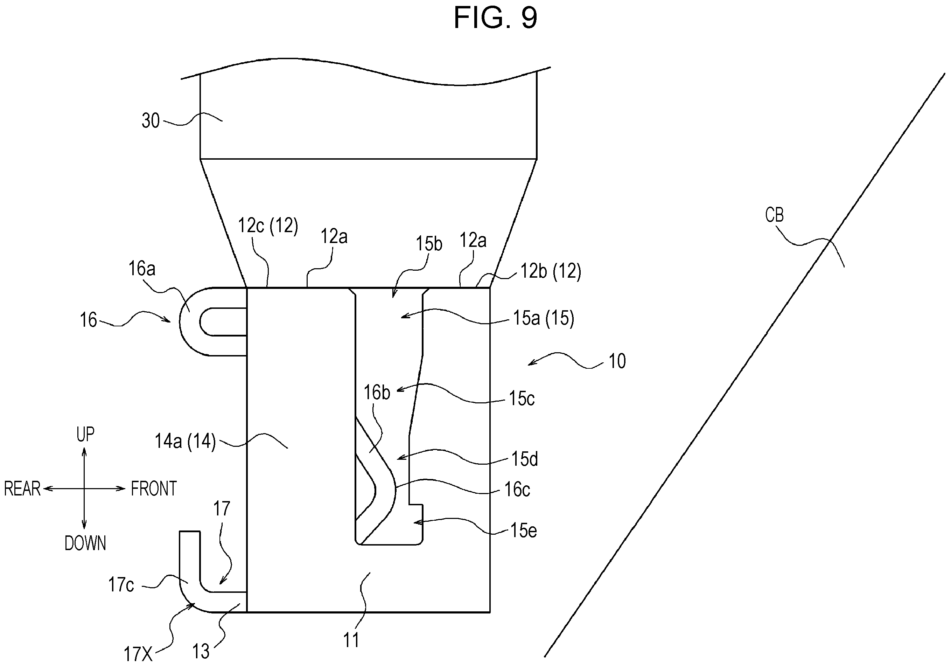

FIG. 9 is a view schematically illustrating the connection component 10 of FIG. 2, in which the connection component 10 is being transported toward the circuit formation surface of the circuit board CB. Referring to FIG. 9, the following describes a process of mounting the connection component 10 onto the circuit board CB.

A mounter (pick-and-place machine) 30 transports the connection component 10 to the circuit formation surface of the circuit board CB. For example, the mounter 30 attracts the suction surface 12a of the connection component 10 by suction before the mounter 30 transports the connection component 10. As described above, the suction surface 12a of the connection component 10 is divided by the first slit 15a into the front and rear portions. Accordingly, the suction surface 12a is not a single continuous surface. Even in this case, the mounter 30 can attract the suction surface 12a of the connection component 10 by suction if the connection component 10 is small and lightweight.

At least one connection component 10 is mounted on the circuit formation surface formed at the upper surface of the circuit board CB. More specifically, the mounter 30 places the connection component 10 on the circuit formation surface at a predetermined position. The mounting portion 17 of the connection component 10 is placed on a bead of solder paste applied on a patterned wiring trace on the circuit board CB. The mounting portion 17 is soldered to the wiring trace by heating and melting the bead of solder paste, for example, in a reflow furnace. The wiring trace to which the connection component 10 is connected is a wiring trace G at ground potential to be used for electronic devices, which ensures the shielding effect. The mounting portion 17 is connected electrically and mechanically to the wiring trace G of the ground potential. Thus, the connection component 10 is connected to the conducting wire of ground potential on the circuit board CB.

For example, when the mounting portion 17 is soldered to the circuit board CB, solder fillets are formed at the mounting portion 17 at multiple positions. For example, a solder fillet is formed along the inside edges of the first base arm 17a1 and the second base arm 17a2 of the mounting portion 17, the inside edges extending along the second slit 17b. For example, a solder fillet is formed along the outside surface of the first bent arm 17c of the mounting portion 17, the outside surface facing rearward. For example, a solder fillet is formed along the inside surface of the second bent arm 17d of the mounting portion 17, the inside surface facing inward in the right-left direction.

Thus, the connection component 10 is mounted on the circuit board CB. In addition to the connection component 10, the above-described other electronic components are also mounted on the circuit formation surface of the circuit board CB.

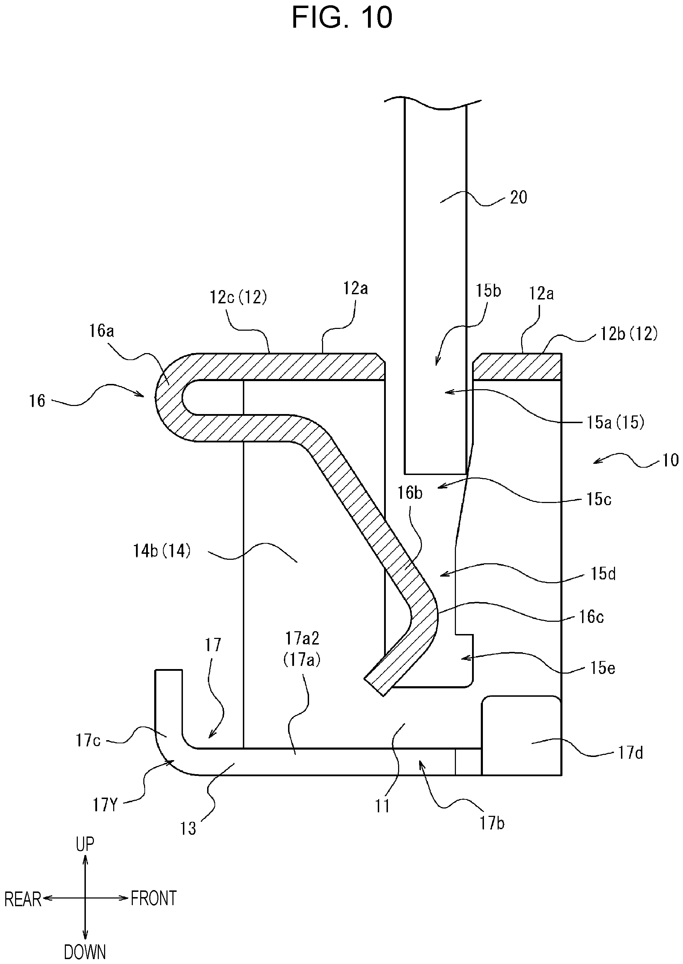

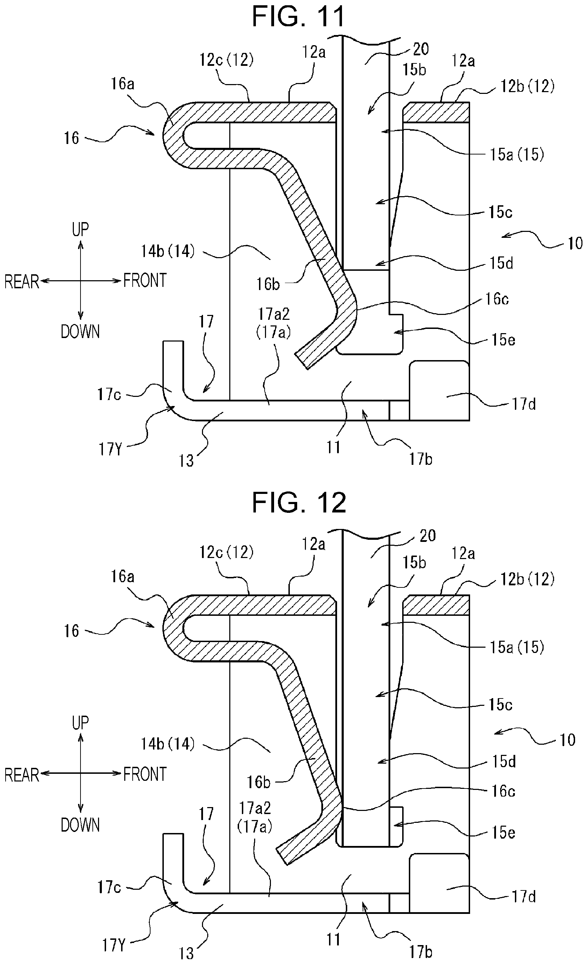

The connection object 20 is inserted from above into at least one connection component 10 mounted on the circuit board CB. FIG. 10 is a first view illustrating a state in which the connection object 20 is being inserted into the connection component 10. FIG. 11 is a second view illustrating a state in which the connection object 20 is being inserted into the connection component 10. FIG. 12 is a third view illustrating a state in which the connection object 20 is being inserted into the connection component 10. FIGs. 10 to 12 are views corresponding to the cross-sectional view of FIG. 8. Referring to FIGs. 10 to 12, the following description focuses on the function of the connection component 10 when the shield module 1 is assembled by attaching the connection object 20 to the connection component 10 mounted on the circuit board CB.

The connection object 20 is placed at a position where the connection object 20 can be inserted into the insertion section 15 of the connection component 10 mounted on the circuit board CB. For example, the connection object 20 is placed directly above the opening 15b of the insertion section 15. As illustrated in FIG. 10, the connection object 20 is inserted from above, and the opening 15b guides the connection object 20 into the insertion section 15.

For example, the connection object 20 may be placed at a position deviating slightly frontward from the center of the support section 15d of the insertion section 15 in the front-rear direction, and the connection object 20 may pass the opening 15b in this state and move downward. In this case, the front corner portion of the connection object 20 at the bottom end thereof comes into contact with the front side edge of each side wall 14 inside the tapered section 15c, the front side edge extending downward and obliquely rearward. The front corner portion of the connection object 20 slides along the front side edge inside the tapered section 15c, which guides the connection object 20 toward the center in the support section 15d in the front-rear direction.

As illustrated in FIG. 11, when the connection object 20 is guided in the tapered section 15c into the support section 15d, the rear corner portion of the connection object 20 at the bottom end thereof comes into contact with the elastic portion 16 that projects into the insertion section 15. For example, the rear corner portion of the connection object 20 comes into contact with the extension 16b of the elastic portion 16. The connection object 20 moves further downward while the rear corner portion of the connection object 20 slides on the extension 16b, which elastically deforms the elastic portion 16 rearward.

As illustrated in FIG. 12, when the connection object 20 moves further down and is completely inserted in the insertion section 15, the bottom surface of the connection object 20 comes into contact with the bottom of the first slit 15a of the insertion section 15. This fixes the position of the connection object 20 in the up-down direction. A front corner of the recess 15e at the bottom of the first slit 15a of the insertion section 15 is rounded. The front corner of the recess 15e is located more frontward relative to the front corner portion of the connection object 20. Accordingly, the bottom surface of the connection object 20 can come into contact with the bottom surface of the first slit 15a in such a manner that both bottom surfaces are aligned parallel to each other. As a result, the connection object 20 can be inserted reliably into the insertion section 15 in the up-down direction.

When the connection object 20 is inserted, the elastic portion 16 comes into contact with the connection object 20 while the elastic portion 16 elastically deforms rearward. For example, the contact 16c of the elastic portion 16 comes into contact with the rear surface of the connection object 20 from behind. Here, the front surface of the connection object 20 comes into contact with the front side edge of each side wall inside the support section 15d. The connection object 20 is nipped between the contact 16c and the front side edge in the support section 15d due to the elastic force of the elastic portion 16. This fixes the position of the connection object 20 in the front-rear direction.

Thus, the connection object 20 is attached to the connection component 10 mounted on the circuit board CB. The assembly of the shield module 1 is thus completed.

The following description focuses on advantageous effects of the connection component 10. These advantageous effects are also applicable to the shield module 1 and the electronic device that contain the connection component 10.

According to the connection component 10 of the present embodiment as described above, the elastic portion 16 of the connection component 10 is not affected by soldering and can elastically deform reliably. For example, in the connection component 10, the side walls 14 are connected to the elastic portion 16. The side walls 14 extend in the first direction in which the elastic portion 16 is elastically deformed. The mounting portion 17 is connected to the side walls 14 extending in the first direction. As illustrated in the cross section of the connection component 10 in FIG. 8, in which the middle portion of the elastic portion 16 is cut in the first direction, the elastic portion 16 does not continue to the mounting portion 17 within the same cross section. The elastic portion 16 is connected to the mounting portion 17 by the side walls 14 that are positioned outside the cross section of FIG. 8. As a result, the elastic deformation of the elastic portion 16 does not easily affect the mounting portion 17. For example, the stress caused by the elastic deformation of the elastic portion 16 is reduced in the mounting portion 17.

For example, in the case of the known contact described in Patent Literature 1, the elastic portion continues to the mounting portion via a ceiling wall and a side wall within the same cross section of the contact cut along the center of the elastic portion in the direction in which the elastic portion deforms elastically. In the known contact, elastic deformation of the elastic portion directly influences the mounting portion easily via the ceiling wall and the side wall. For example, the stress caused by the elastic deformation of the elastic portion is greater in the mounting portion.

According to the connection component 10 of the present embodiment, however, the elastic deformation of the elastic portion 16 does not much influence the mounting portion 17, which reduces the likelihood of the elastic deformation of the elastic portion 16 generating cracks in the solder in the mounting portion 17. This improves reliability of the shield module 1 and the electronic device that contain the connection component 10.

The connection component 10 includes the ceiling wall 12 that extends inward from the edge E of each side wall 14 in the second direction that orthogonally intersects the first direction, the edge E being located opposite to the edge near the mounting portion 17. The mounter 30 can attract the ceiling wall 12 by suction and transport the connection component 10 as illustrated in FIG. 9. Accordingly, the mounter 30 can place the connection component 10 easily at a specific position on the circuit formation surface of the circuit board CB. This improves work efficiency in mounting the connection component 10 onto the circuit board CB.

In the connection component 10, the elastic portion 16 is located between the ceiling wall 12 and the mounting portion 17 in the up-down direction, which enables size reduction of the connection component 10 in the front-rear and the right-left directions. Accordingly, the mounting area of the connection component 10 in contact with the circuit formation surface of the circuit board CB is reduced, which leads to size reduction of the circuit board CB. Accordingly, the connection component 10 can contribute further to the size reduction of the shield module 1 and the electronic device.

The elastic portion 16 is firmly connected to the ceiling wall 12 and further to the side walls 14 via the ceiling wall 12. This contributes to stable elastic deformation of the elastic portion 16. Accordingly, this further reduces the stress in the mounting portion 17 caused by the elastic deformation of the elastic portion 16. As a result, the elastic deformation of the elastic portion 16 does not much influence the mounting portion 17, which further reduces the likelihood of the elastic deformation of the elastic portion 16 causing cracks in the solder in the mounting portion 17. This further improves the reliability of the shield module 1 and the electronic device that contain the connection component 10.

The elastic portion 16 extends from the edge of the ceiling wall 12 located in the first direction, turns back, and projects into the insertion section 15. As a result, the elastic portion 16 becomes largely deformable compared with a case, for example, in which the elastic portion 16 projects from the front edge of the second ceiling wall 12c. This results in easy insertion of the connection object 20 into the connection component 10 and enables a highly reliable connection between the connection object 20 and the connection component 10 even if, for example, the thickness of the connection object 20 is not uniform. Moreover, in the configuration in which the elastic portion 16 extends from the ceiling wall 12, the area of the suction surface 12a of the ceiling wall 12 can be made larger compared with a case, for example, in which the elastic portion 16 extends from the front edge of the second ceiling wall 12c. This contributes to a better workability of the mounter 30 in picking up the connection component 10 by suction.

The side walls 14 includes the first side wall 14a and the second side wall 14b that oppose each other in the second direction with the elastic portion 16 located therebetween. This enables the elastic portion 16 to be protected in the right-left direction. The elastic portion 16 can be disposed between the side walls 14, in other words, between the first side wall 14a and the second side wall 14b, without the elastic portion 16 being exposed to the outside in the right-left direction. This reduces the likelihood of the elastic portion 16 being touched by mistake, during assembly work, by the mounter 30 or machines for assembling the shield module 1 and the electronic device or by an operator. This reduces the likelihood of the elastic portion 16 being damaged. As a result, the product reliability of the shield module 1 and the electronic device that contain the connection component 10 can be improved.

The elastic portion 16 is located between the ceiling wall 12 and the mounting portion 17 in the up-down direction, which enables the elastic portion 16 to be protected in the up-down direction. The elastic portion 16 can be disposed between the ceiling wall 12 and the mounting portion 17 without the elastic portion 16 being exposed to the outside in the up-down direction. This reduces the likelihood of the elastic portion 16 being touched by mistake, during assembly work, by the mounter 30 or machines for assembling the shield module 1 and the electronic device or by an operator. This reduces the likelihood of the elastic portion 16 being damaged. As a result, the product reliability of the shield module 1 and the electronic device that contain the connection component 10 can be improved.

The elastic portion 16 are protected by the first side wall 14a and the second side wall 14b in the right-left direction and also by the ceiling wall 12 and the mounting portion 17 in the up-down direction, which enhances the above reliability-relates effects.

The insertion section 15 includes the first slit 15a that is formed through the ceiling wall 12 into the first side wall 14a and into the second side wall 14b in the insertion direction of the connection object 20 that orthogonally intersects the first direction and the second direction. The first slit 15a regulates the position of the connection object 20 relative to the insertion section 15, which can prevent an excess deformation of the elastic portion 16. The first slit 15a prevents the connection object 20 from vibrating or sliding after the connection object 20 is attached to the connection component 10, which can maintain a reliable contact between the connection object 20 and the connection component 10. As a result, the reliability of the shield module 1 and the electronic device is improved.

The mounting portion 17 overlaps the elastic portion 16 as viewed in the insertion direction of the connection object 20 being inserted into the insertion section 15, and the mounting portion 17 is located at a position closer than the elastic portion 16 to the circuit board CB. This enables size reduction of the connection component 10 in the front-rear and right-left directions. Accordingly, the mounting area of the connection component 10 in contact with the circuit formation surface of the circuit board CB is reduced, which leads to size reduction of the circuit board CB. Accordingly, the connection component 10 can contribute to the size reduction of the shield module 1 and the electronic device.

The mounting portion 17 includes the first bent arm 17c that is shaped like the letter L and projects outward in the first direction from the edge of the base arm 17a, the edge extending in the second direction. This facilitates solder fillet formation, for example, along the outside surface of the first bent arm 17c that faces rearward. This increases the mounting strength of the connection component 10 mounted on the circuit board CB. The connection components 10 are packed in a so-called tape-and-reel form. The connection components 10 are accommodated in accommodation pockets of an embossed tape, and a carrier tape, which serves as a cover tape, is bonded on the embossed tape so as to close the accommodation pockets. The first bent arm 17c reduces the likelihood of the connection component 10 toppling in the pocket.

The mounting portion 17 includes the second slit 17b that extends through the base arm 17a in the first direction. The second slit 17b enables solder fillets to be formed easily, for example, along the inside edges of the first base arm 17a1 and the second base arm 17a2, the inside edges facing the second slit 17b. Moreover, the second slit 17b of the mounting portion 17 can receive an excess amount of solder. This increases the mounting strength of the connection component 10 mounted on the circuit board CB.

In addition, the mounting portion 17 of the connection component 10 is divided by the second slit 17b into the first mounting portion 17X and the second mounting portion 17Y, which contributes to reliable positioning and fixation of the connection component 10. More specifically, the first mounting portion 17X and the second mounting portion 17Y of the connection component 10 are placed on a bead of solder paste. During reflow of the solder, the surface tension of melted solder acts on the first mounting portion 17X and the second mounting portion 17Y and moves the connection component 10 so as to reach equilibrium. As a result, the connection component 10 can be disposed easily at the mounting position on the circuit formation surface of the circuit board CB. In other words, the connection component 10 can be disposed at substantially the same position on the circuit formation surface of the circuit board CB if the conditions of the solder, such as the amount and position of application, remain substantially the same when the solder is applied on a wiring trace on the circuit board CB.

The mounting portion 17 includes the second bent arm 17d that is shaped like the letter L and projects inward in the second direction from the edge of the base arm 17a that extends along the second slit 17b. This facilitates solder fillet formation, for example, along the inside surface of the second bent arm 17d that faces inward in the right-left direction. This increases the mounting strength of the connection component 10 mounted on the circuit board CB.

The insertion section 15 is formed so as to have an asymmetrical shape in the front-rear direction in such a manner that the edge of each side wall only on one side in the first slit 15a incline. As a result, the area of the suction surface 12a of the ceiling wall 12 becomes larger compared with a case in which the edges of each side wall on both sides in the first slit 15a in the front-rear direction incline symmetrically. This contributes to a better workability of the mounter 30 in picking up the connection component 10 by suction.

In the case of the connection object 20 being the shielding case, the shield module 1 can block noise effectively. For example, the shield module 1 can effectively block external noise affecting the electronic components located inside the connection object 20 or block noise leaking out from the electronic components inside the connection object 20.

Those skilled in the art can obviously implement the present disclosure in a form other than the above-described embodiment without departing from the spirit or the essential features of the present disclosure. In this sense, the present disclosure is not limited to the above description, which is only illustrative. The scope of the disclosure is not limited by the above description but by the appended claims. Changes and alterations that fall within the scope of the claims or the equivalents thereof are to be included in the scope of the present disclosure.

For example, the shapes, arrangements, orientations of the elements as well as the number of the elements are not limited to what is disclosed in the above description and in the drawings. The shapes, arrangements, and orientations of the elements as well as the number of the elements may be changed arbitrarily insofar as the specified functions can be implemented.

In the above embodiment, the connection component 10 includes the ceiling wall 12 that extends inward from the edge E of each side wall 14 in the second direction that orthogonally intersects the first direction. The edge E of each side wall 14 is located opposite to the edge near the mounting portion 17. The ceiling wall 12 of the connection component 10, however, is not limited to this. The ceiling wall 12 does not need to extend inward from the edge E of each side wall 14 but may extend inward in the second direction from each side wall 14 at any arbitrary position in the up-down direction. Moreover, the connection component 10 does not need to include the ceiling wall 12 at all.

In the above embodiment, the ceiling wall 12 connects the elastic portion 16 to the side walls 14. The elastic portion 16, however, may be connected directly to the side walls 14 at any arbitrary position in the up-down direction.

In the above embodiment, the elastic portion 16 extends from the edge of the ceiling wall 12 in the first direction, turns back, and projects into the insertion section 15. The elastic portion 16, however, may extend from the ceiling wall 12 in any arbitrary form. For example, the elastic portion 16 may project from the front edge of the second ceiling wall 12c into the insertion section 15.

In the above embodiment, the side walls 14 include the first side wall 14a and the second side wall 14b that oppose each other in the second direction with the elastic portion 16 located therebetween. However, a single side wall 14 may be provided, and the single side wall 14 may be either the first side wall 14a or the second side wall 14b.

In the above embodiment, the insertion section 15 includes the first slit 15a that is formed through the ceiling wall 12 into the first side wall 14a and into the second side wall 14b in the insertion direction of the connection object 20. The insertion section 15 may include an arbitrary supporting structure that supports the connection object 20 in place of, or in addition to, the first slit 15a.

In the above embodiment, the mounting portion 17 overlaps the elastic portion 16 as viewed in the insertion direction in which the connection object 20 is inserted into the insertion section 15, and the mounting portion 17 is located at the position closer than the elastic portion 16 to the circuit board CB. The mounting portion 17, however, does not need to overlap the elastic portion 16 as viewed in the insertion direction of the connection object 20 being inserted into the insertion section 15. The position of the mounting portion 17 may be deviated from the position of the elastic portion 16 in at least one of the front-rear and the right-left directions.

In the above embodiment, the mounting portion 17 includes the first bent arm 17c that is shaped like the letter L and projects outward in the first direction from the edge of the base arm 17a, the edge extending in the second direction. The mounting portion 17, however, does not need to include the first bent arm 17c.

In the above embodiment, the mounting portion 17 includes the second slit 17b that extends in the first direction through the base arm 17a. The mounting portion 17, however, does not need to include the second slit 17b.

In the above embodiment, the mounting portion 17 includes the second bent arm 17d that is shaped like the letter L and projects inward in the second direction from the edge of the base arm 17a that extends along the second slit 17b. The mounting portion 17, however, does not need to include the second bent arm 17d.

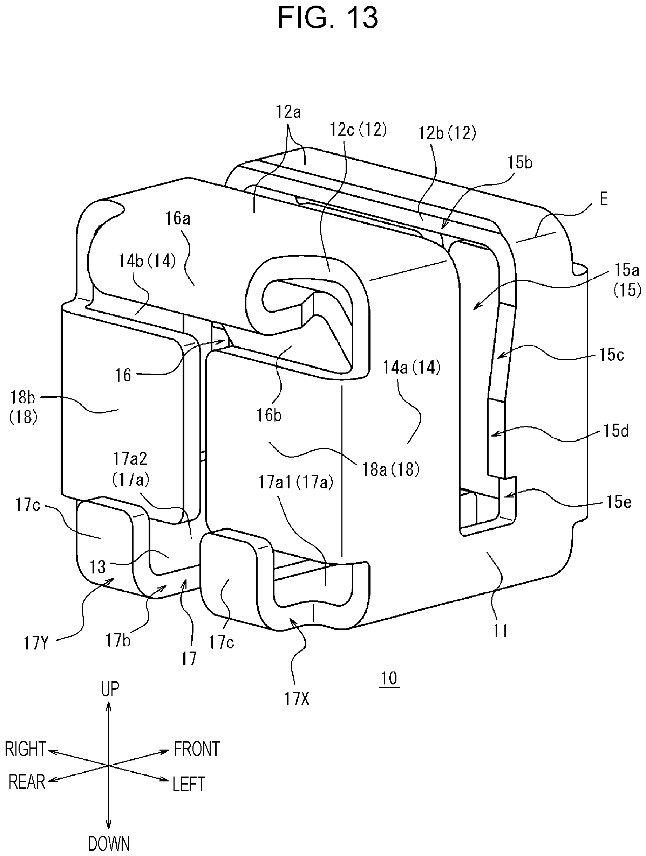

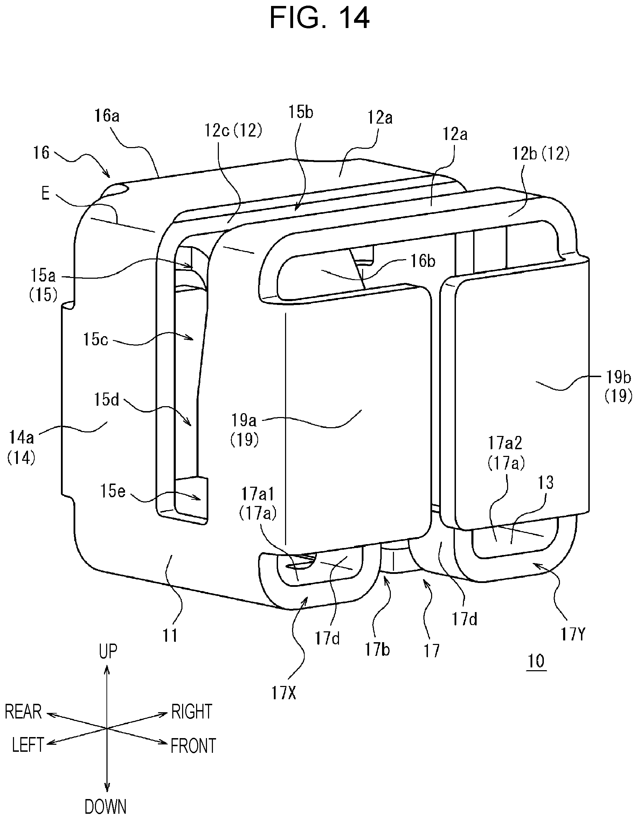

FIG. 13 is a perspective view illustrating the exterior of a connection component 10 according to a variation as viewed from above. FIG. 13 corresponds to the perspective view of FIG. 2. FIG. 14 is a perspective view illustrating the exterior of the connection component 10 of FIG. 13 as viewed from an opposite side. Referring to FIGs. 13 and 14, the following description focuses on the structure of the connection component 10 of the variation. The same elements as those of the connection component 10 of FIG. 2 are denoted by the same reference signs, and duplicated descriptions are omitted. The following description focuses on elements that are different from those of the connection component 10 of FIG. 2.

In the above embodiment, the elastic portion 16 is protected in the up-down and the right-left directions in the connection component 10. The elastic portion 16, however, may be protected in the connection component 10 in the front-rear direction as well as in the up-down and the right-left directions.

For example, as illustrated in FIG. 13, the connection component 10 includes a rear wall 18 that extends inward in the right-left direction from a middle portion of the rear edge of each side wall 14. For example, the rear wall 18 may include a first rear wall 18a and a second rear wall 18b. The first rear wall 18a extends inward in the right-left direction from a middle portion of the rear edge of the first side wall 14a. The second rear wall 18b extends inward in the right-left direction from a middle portion of the rear edge of the second side wall 14b. The rear wall 18 is not limited to the configuration in which the first rear wall 18a and the second rear wall 18b are separated in the right-left direction. The rear wall 18 may include a single wall that extends in the right-left direction between the first side wall 14a and the second side wall 14b.

For example, as illustrated in FIG. 14, the connection component 10 includes a front wall 19 that extends inward in the right-left direction from a middle portion of the front edge of each side wall 14. For example, the front wall 19 may include a first front wall 19a and a second front wall 19b. The first front wall 19a extends inward in the right-left direction from a middle portion of the front edge of the first side wall 14a. The second front wall 19b extends inward in the right-left direction from a middle portion of the front edge of the second side wall 14b. The front wall 19 is not limited to the configuration in which the first front wall 19a and the second front wall 19b are separated in the right-left direction. The front wall 19 may include a single wall that extends in the right-left direction between the first side wall 14a and the second side wall 14b.

With the above configuration, the elastic portion 16 is protected in every direction in the connection component 10, which can improve the noise blocking effect for the connection portion between the contact 16c of the elastic portion 16 and the contact part of the connection object 20. In addition, this increases the surface area of the connection component 10 exposed to the outside, which improves heat radiation. Electronic components mounted on the circuit board CB inside the connection object 20 generate heat, and the connection component 10 can dissipate the heat to the outside efficiently.

The connection component 10 or the shield module 1 is mounted in an electronic device. For example, the electronic device may be an arbitrary vehicle-mounted device, such as a camera, a radar, a car digital video recorder, or an engine control unit. For example, the electronic device may be an arbitrary vehicle-mounted device to be used in an onboard system, such as a car navigation system, an advanced driver-assistance system, or a security system. Moreover, the electronic device may be any arbitrary industrial device. The electronic device is not limited to the above, but may be, for example, an arbitrary information device, such as a smartphone, a personal computer, a copier, a printer, a facsimile, or a multifunction printer. The electronic device may also be an arbitrary audio-visual device, such as a liquid crystal display television, a recorder, a camera, and a headphone.

The connection component 10 or the shield module 1 as described above improves the product reliability of such electronic devices.

### REFERENCE SIGNS

- 1: shield module
- 10: connection component
- 11: circumferential wall
- 12: ceiling wall
- 12a: suction surface
- 12b: first ceiling wall
- 12c: second ceiling wall
- 13: bottom wall
- 14: side wall
- 14a: first side wall
- 14b: second side wall
- 15: insertion section
- 15a: first slit
- 15b: opening
- 15c: tapered section
- 15d: support section
- 15e: recess
- 16: elastic portion
- 16a: folded portion
- 16b: extension
- 16c: contact
- 17: mounting portion
- 17X: first mounting portion
- 17Y: second mounting portion
- 17a: base arm
- 17a1: first base arm
- 17a2: second base arm
- 17b: second slit
- 17c: first bent arm
- 17d: second bent arm
- 18: rear wall
- 18a: first rear wall
- 18b: second rear wall
- 19: front wall
- 19a: first front wall
- 19b: second front wall
- 20: connection object
- 30: mounter
- CB: circuit board
- E: edge
- G: wiring trace

## Claims

1. A connection component for connecting a connection object to a circuit board, the connection component comprising:
an insertion section configured to receive the connection object;
an elastic portion to come in contact with the connection object;
a side wall connected to the elastic portion and elongated in a first direction in which the elastic portion deformable elastically; and
a mounting portion connected to the side wall, and configured to be disposed on the circuit board.

2. The connection component according to claim 1, further comprising:
a ceiling wall extending inward from an edge of the side wall in the second direction orthogonal to the first direction, the edge being located opposite to an edge near the mounting portion.

3. The connection component according to claim 2, wherein,
the side wall includes a first side wall and a second side wall that oppose each other in the second direction with the elastic portion located therebetween.

4. The connection component according to claim 3, wherein,
the elastic portion is coupled to the side wall with the ceiling wall therebetween.

5. The connection component according to claim 4, wherein,
the elastic portion extends from the ceiling wall, turns back, and projects into the insertion section.

6. The connection component according to claim 5, wherein,
the insertion section includes a first slit being formed through the ceiling wall into the first side wall and into the second side wall in an insertion direction of the connection object, the insertion direction orthogonally intersecting the first direction and the second direction.

7. The connection component according to any one of claims 1 to 6, wherein,
the mounting portion overlaps the elastic portion as viewed in the insertion direction in which the connection object is inserted into the insertion section, and
the mounting portion is located at a position closer than the elastic portion to the circuit board.

8. The connection component according to any one of claims 1 to 7, wherein,
the mounting portion comprises a base arm projecting inward in the second direction, which orthogonally intersects the first direction, from an edge of the side wall, the edge near the mounting portion.

9. The connection component according to claim 8, wherein,
the mounting portion includes a first bent arm being bent at a position outward in the first direction from an edge of the base arm, the edge extending in the second direction.

10. The connection component according to claim 8 or 9, wherein,
the mounting portion comprises a second slit extending in the first direction through the base arm.

11. The connection component according to claim 10, wherein,
the mounting portion comprises a first mounting portion and a second mounting portion opposing each other with the second slit located therebetween, and
the first mounting portion is connected to the first side wall, and the second mounting portion is connected to the second side wall.

12. The connection component according to claim 11, wherein,
the mounting portion comprises a second bent arm being bent at a position inward in the second direction from an edge of the base arm, the edge extending along the second slit.

13. A shield module, comprising:
the connection component according to any one of claims 1 to 12; and
the connection object being inserted in the insertion section and connected to the circuit board by the connection component, wherein
the connection object comprises a shielding case.

14. The shield module according to claim 13, wherein
the connection component is connected to a conducting wire of ground potential on the circuit board.

15. An electronic device, comprising:
either one of the connection component according to any one of claims 1 to 12 and the shield module according to claim 13 or 14.
